**Europäisches Patentamt**

(19) **European Patent Office**

**Office européen des brevets**

(11) Publication number: **0 036 137**
**B1**

(12) **EUROPEAN PATENT SPECIFICATION**

(45) Date of publication of patent specification: **23.01.85**

(21) Application number: **81101579.1**

(22) Date of filing: **05.03.81**

(51) Int. Cl.⁴: **H 01 L 21/26**

(54) **Method for production of semiconductor devices.**

(30) Priority: **10.04.80 JP 47346/80**
**11.03.80 JP 30623/80**
**11.03.80 JP 30624/80**
**11.04.80 JP 47656/80**

(43) Date of publication of application:
**23.09.81 Bulletin 81/38**

(45) Publication of the grant of the patent:
**23.01.85 Bulletin 85/04**

(84) Designated Contracting States:
**DE FR GB NL**

(56) References cited:
**DE-A-2 837 750**
**US-A-3 335 038**
**US-A-3 585 088**

**IBM TECHNICAL DISCLOSURE BULLETIN, Vol. 16, No. 10, March 1974, New York G.L. HUTCHINS et al. "Fabricating Isolated Device-Quality Semiconductor Film Areas on a Foreign Substrate Using Laser Melting"**

(73) Proprietor: **FUJITSU LIMITED**
**1015, Kamikodanaka Nakahara-ku**
**Kawasaki-shi Kanagawa 211 (JP)**

(72) Inventor: **Sakurai, Junji**
**7-11, Seta 4-chome**
**Setagaya-ku Tokyo 158 (JP)**

(74) Representative: **Seeger, Wolfgang, Dipl.-Phys.**
**European Patent Attorney Bereiteranger 15**
**D-8000 München 90 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

## Description

This invention relates to a method for production of a semiconductor device, more particularly to a method for production of a semiconductor device which is produced on a single crystalline semiconductor layer which is converted employing an energy ray irradiation process applied to a polycrystalline or amorphous semiconductor layer which is grown on an insulating layer which is produced on a silicon or quartz substrate.

A semiconductor device produced on an insulator has various advantages in comparison with a semiconductor device produced on a monolithic semiconductor substrate, because the parasitic effects are reduced or even eliminated, resulting in a higher integration and higher switching speed of the device. It is widely known that silicons on sapphire and silicons on magnesia spinel are respectively in practical and potential use.

This category of semiconductor devices has gained more significance particularly from a practical view-point since a process was successfully developed for the conversion of polycrystalline silicon or amorphous silicon into single crystalline silicon employing an irradiation process with laser or some other energy rays. In reality, it has become possible to produce a semiconductor device on a single crystalline silicon layer which is converted from a polycrystalline silicon layer which is grown on a silicon dioxide layer which is produced on a silicon substrate.

Due to the nature or the technical requirements involved with the energy ray irradiation process for conversion of non-single crystalline semiconductor to single crystalline semiconductor, however, some possibilities have remained for further improvement of the various processes which are based on and utilize the aforementioned crystal structure conversion process, particularly the process to convert polycrystalline silicon to single crystalline silicon employing an irradiation process with laser or some other energy rays.

Some of such possibilities for further improvement are itemized below:

1. Removal of the difficulty involved in the scribing process for splitting each chip of the finished semiconductor devices due to the higher hardness of insulating layer. In the case of scribing a semiconductor substrate or wafer with a diamond cutter, the blade of the cutter is easily damaged. In the case of scribing a semiconductor substrate employing a laser cutting process, a longer time or a higher power is required, causing a drawback from a practical viewpoint.

2. Removal of the difficulty of making the surface of the converted single crystalline semiconductor layer plane and smooth. Because perforations are required sporadically in an insulating layer for the purpose of providing crystal nuclei, it is not necessarily easy to produce a plane and smooth surface of the single crystalline semiconductor layer which is converted from a non-single crystalline semiconductor layer particularly on the perforations. Since a number of fine patterns are required to be produced on the single crystalline semiconductor layer during a semiconductor device production process, the surface of the single crystalline semiconductor layer is required to be absolutely plane and smooth.

3. Removal of the difficulty in production of a planar type semiconductor device. It is not necessarily easy to produce a field insulator region for a single crystalline semiconductor layer converted from a non-single crystalline semiconductor layer employing an energy ray irradiation process for the conversion of a polycrystalline semiconductor to a single crystalline semiconductor. Therefore, mesa type semiconductor devices have been predominantly produced employing such converted single crystalline semiconductor layers. Since a planar type semiconductor device is preferable rather than a mesa type semiconductor device, this difficulty in the production of a planar type semiconductor device is an unallowable drawback.

4. Removal of the possibility of causing damage to a converted single crystalline semiconductor layer during the high temperature oxidation process for the production of a field oxide layer. Experimental results show that the single crystalline silicon converted from the polycrystalline silicon employing an energy ray irradiation process, is readily damaged by exposure to high temperature. Therefore, a method for the production of a field oxide layer without damaging the converted single crystalline semiconductor layer is essential for efficient utilization of the process to convert polycrystalline semiconductor to a single crystalline semiconductor layer employing an energy ray irradiation process.

5. Development of a process for the conversion of a non-single crystalline semiconductor to a single crystalline semiconductor without requiring crystal nuclei. A crystal nucleus is usually required to cause a molten material to crystallize. It is extremely convenient if a process is available which requires no crystal nuclei.

6. Development of a process which enables deep and uniform distribution of impurities without lateral diffusion in a semiconductor layer. With a heating system employing a furnace, it is difficult to realize deep and uniform distribution of impurites without lateral diffusion, because a wafer is required to be exposed to high temperature for a relatively long time, which results in an isotropic diffusion with non-uniform Gaussian distribution of impurities. A lateral diffusion of impurities causes a less integration grade of semiconductor devices. A high surface impurities density caused by a non-uniform distribution of impurities in depth causes a bad crystal quality, resulting in a smaller mobility of the carriers. This type of drawbacks readily nullifies various advantages caused by the process for the conversion of a polycrystalline semiconductor to single crystalline semiconductor employing an energy ray irradiation process.

7. Development of a process for the production of an embedded semiconductor resistor which has a definite and uniform magnitude of resistance and a geometrical accuracy. The essential requirements for an embedded semiconductor resistor are less magnitude in the dispersion of resistance and less magnitude in the lateral diffusion. The former is the basic requirements of a resistor. The latter is necessary to increase the grade of integration. The deep and uniform diffusion of impurities without lateral diffusion is effective to realize these requirements. It is difficult for a diffusion process employing a furnace to enable the aforementioned deep and uniform diffusion of impurities without lateral diffusion. Therefore, development of a process which enables deep and uniform diffusion of impurities without lateral diffusion, referred to in Item 6, can be diversified to a process for production of an embedded semiconductor resistor with an allowable performance.

8. Improvement of a process for the production of a mesa type semiconductor device utilizing a single crystalline semiconductor layer converted from a polycrystalline semiconductor layer employing the aforementioned energy ray irradiation process for conversion of a polycrystalline semiconductor to a single crystalline semiconductor. Albeit it is relatively easy to produce a mesa type semiconductor device rather than a planar type semiconductor device, it is observed that there is a tendency for the surface of the mesa side to be rough and for the edge of the mesa to be sharp. This tendency causes a discontinuity of metal wirings to be produced thereon.

The first object of this invention is to provide a method for the production of semiconductor devices which method comprises an easy scribing process for splitting each chip of a finished semiconductor device.

The second object of this invention is to provide a method for the production of semiconductor devices in which method it is readily possible to produce a plane and smooth surface of a single crystalline semiconductor layer which is converted from a non-single crystalline semiconductor layer employing an energy ray irradiation process for conversion of a non-single crystalline semiconductor to a single crystalline semiconductor.

The third object of this invention is to provide a method for the production of semiconductor devices which enables easy production of a planar type semiconductor device employing a single crystalline semiconductor layer converted from a non-single crystalline semiconductor layer.

The fourth object of this invention is to provide a method for the production of semiconductor devices in which method a high temperature oxidation process for the production of a field oxide layer is prevented from damaging a converted single crystalline semiconductor layer.

The fifth object of this invention is to provide a method for the production of semiconductor devices which method enables the conversion of a. non-single crystalline semiconductor to a single crystalline semiconductor without requiring crystal nuclei.

The sixth object of this invention is to provide a method for the production of semiconductor devices which method enables deep and uniform distribution of impurities without lateral diffusion in a semiconductor layer.

The seventh object of this invention is to provide a method for the production of semiconductor devices which method is involved with a process for the production of an embedded semiconductor resistor which has a definite and uniform magnitude of resistance and an accurate geometry.

To attain the first and second objects mentioned above, a method for the production of semiconductor devices in accordance with the present invention comprises a step to produce an insulating layer on the top surface of a semiconductor substrate, a step to produce at least one window in said insulating layer along at least one elongated area on which a scribe line is scheduled to be produced, a step to grow a non-single crystalline semiconductor layer on the top surface of the insulating layer and on the substrate surface which is exposed through the window, a step to irradiate said non-single crystalline semiconductor layer with an energy ray selected from a group consisting of a photon beam, an ion beam, and an electron beam, to convert said non-single crystalline semiconductor layer into a monocrystalline layer, and subsequently, a step of scribing the line in the region where the said window is provided in the insulating layer.

To attain the third and fourth objects mentioned above, a method for the production of semiconductor devices in accordance with the present invention comprises a step to grow a further non-single crystalline semiconductor layer on the top surface of a semiconductor substrate,

a step to selectively oxidize at least one selected area designated in said further non-single crystalline semiconductor layer, and

a step to irradiate said further non-single crystalline semiconductor layer, adjoining the selected oxidized area, with an energy ray selected from a group consisting of a photon beam, an ion beam, and an electron beam, to convert said further non-single crystalline semiconductor layer into a monocrystalline layer.

To attain the sixth and seventh objects mentioned above, a method for the production of semiconductor devices in accordance with the present invention further comprises a step to cover at least one selected area of a further semiconductor layer with a mask made on a material which prevents heat supplied in the form of radiation, from passing therethrough, a step to deposit impurities in the uncovered area of said further semiconductor layer, a step to irradiate the uncovered area of said further semiconductor layer so as to recrystallize it with an energy ray selected from a group consisting of a photon beam, an ion beam and an electron beam, whereby the deposited impurities diffuse into the recrystallized semiconductor layer. This irradiation may last for a short period for melting the semiconductor layer to a limited depth and recrystallizing the same to cause the deposited impurities to be distributed without an appreciable lateral diffusion and in the uniform density for a considerable magnitude of depth.

Under the category of this embodiment, a modification is available to prevent potential drawbacks which may cause unsatisfactory performance in the conversion of a polycrystalline semiconductor to a single crystalline semiconductor and unintentional doping. In other words, some types of materials, such as aluminium, to be employed as the mask for an energy ray irradiation process could react with or could be doped into the semiconductor to be converted to a single crystalline semiconductor to cause the aforementioned potential drawbacks. To prevent these possibilities from occuring, the polycrystalline semiconductor layer to be converted to a single crystalline semiconductor layer is covered by a thin layer made of a material which is non-reactive with the specific semiconductor and can not be a dopant for the specific semiconductor. In the case of silicon, silicon dioxide has been determined to perform a satisfactory function.

The present invention, together with its various features and advantages, can be readily understood from the following more detailed description presented in conjunction with the following drawings, in which:

Fig. 1 shows a cross-sectional view of a semiconductor substrate after completion of the second step of a method for the production of semiconductor devices in accordance with the first embodiment of the present invention,

Fig. 2 shows a cross-sectional view of a semiconductor substrate after completion of the third step of a method for the production of semiconductor devices in accordance with the first embodiment of the present invention,

Fig. 3 shows a cross-sectional view of a semiconductor substrate after completion of the fourth step of a method for the production of semiconductor devices in accordance with the first embodiment of the present invention,

Fig. 4 shows a cross-sectional view of a completed semiconductor device produced employing a method for the production of semiconductor devices in accordance with the first embodiment of the present invention,

Fig. 5 shows a cross-sectional view of a completed multi-layered semiconductor device produced employing a method for the production of semiconductor devices in accordance with the first embodiment of the present invention,

Fig. 6 shows a cross-sectional view of a semiconductor substrate after completion of the third step of a method for the production of semiconductor devices in accordance with the second embodiment of the present invention,

Fig. 7 shows a cross-sectional view of a semiconductor substrate after completion of the fifth step of a method for the production of semiconductor devices in accordance with the second embodiment of the present invention,

Fig. 8 shows a cross-sectional view of a completed semiconductor device produced employing a method for the production of semiconductor devices in accordance with the second embodiment of the present invention,

Fig. 9 shows a cross-sectional view of a semiconductor substrate after completion of the second step of a method for the production of semiconductor devices in accordance with the third embodiment of the present invention,

Fig. 10 shows a cross-sectional view of a semiconductor substrate after completion of the fifth step of a method for the production of semiconductor devices in accordance with the third embodiment of the present invention,

Fig. 11 shows a cross-sectional view of a semiconductor substrate after completion of the eighth step of a method for the production of semiconductor devices in accordance with the fourth embodiment of the present invention,

Fig. 12 shows a cross-sectional view of a semiconductor substrate after completion of the ninth step of a method for the production of semiconductor devices in accordance with the fourth embodiment of the present invention.

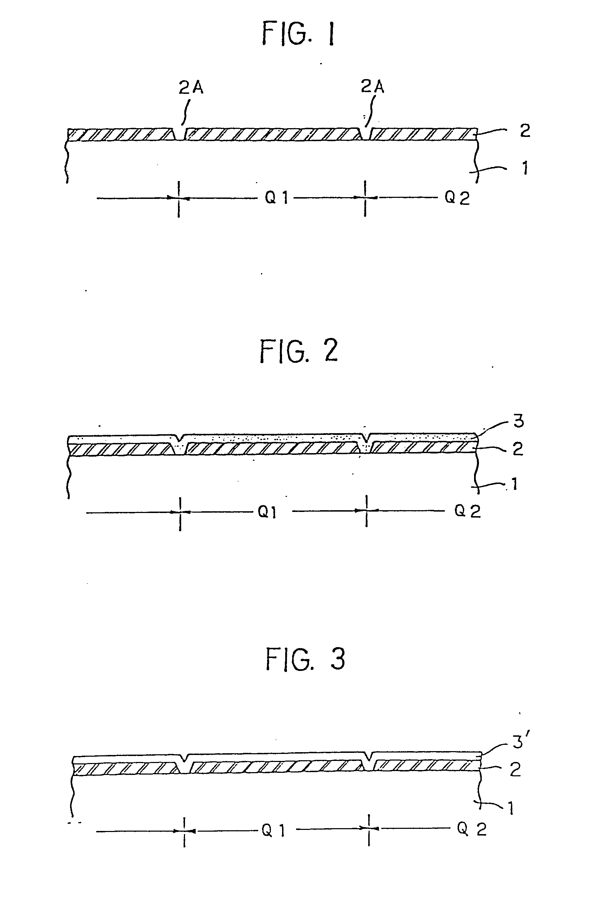

Referring to Figs. 1 through 4, each step of the first embodiment in accordance with the present invention which is realized to attain the first and second objects mentioned above, on a silicon (Si) substrate will be described below:

Referring to Fig. 1, the first step is to apply a thermal oxidation process to an N type silicon substrate 1 which has the resistance of 0.5 ohm-cm and is sliced along the (111) crystalline surface for production of a silicon dioxide ($S_iO_2$) layer 2 having the approximate thickness of 1 micrometer.

Thereafter, a conventional photo lithography process is employed for patterning the silicon dioxide layer 2. This patterning process produces windows 2A in the silicon dioxide layer 2 along the linear areas on which scribe lines are scheduled to be cut. In this process, patterning accuracy is not necessarily required in the vertical direction.

Referring to Fig. 2, the third step is to employ a chemical vapor deposition process for growing a polycrystalline silicon layer 3 with the approximate thickness of 0.5 micrometer.

Referring to Fig. 3, the fourth step is to irradiate the polycrystalline silicon layer 3 with a laser beam for its conversion into a single crystalline silicon layer 3'. Since crystal nuclei are provided from the single crystalline silicon substrate 1 through the windows 2A, no perforations are required in the silicon dioxide layer 2. Therefore, the top surface of each chip $Q_1$, $Q_2$, et al. is readily made plane and smooth.

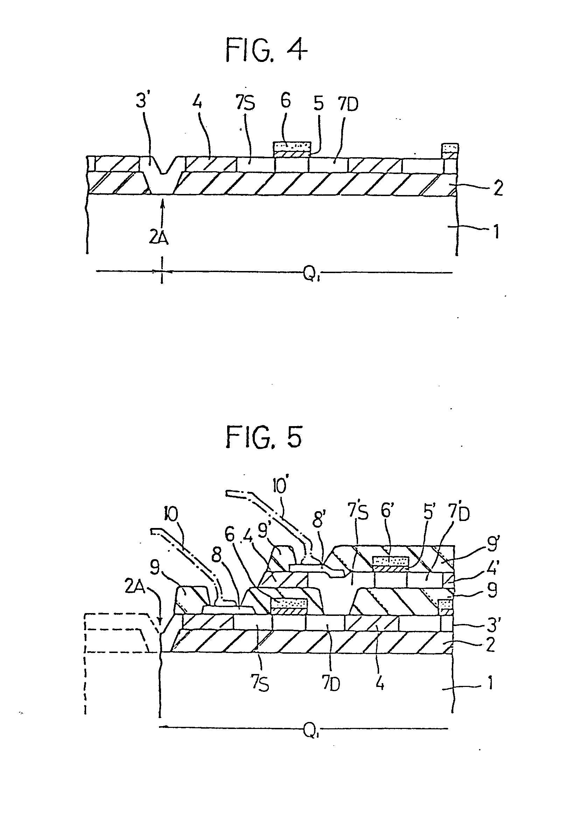

The subsequent steps are quite similar to those which are employed for production of an ordinary semiconductor device. Fig. 4 shows a silicon gate type MIS field effect transistor formed in said single crystalline layer 3'. Referring to Fig. 4, field oxide layers 4, gate insulating layers 5, silicon gate electrodes 6, source regions $7_s$, drain regions $7_D$ are produced. It is quite natural that passivation layers such as a phosphosilicate glass layer (not shown) and wirings (not shown) are produced.

The final step is to split each chip $Q_1$, $Q_2$, et al. of the finished semiconductor device employing a diamond cutter, a laser cutter or some other means. Because the hardness of silicon is much less than that of silicon dioxide, this step can readily be carried out without damaging the blade of the diamond cutter or without requiring a long time or a high power.

Accordingly, in accordance with the first embodiment of the present invention, a method for the production of semiconductor devices which comprises an easy scribing process for splitting each chip of the finished semiconductor device and which enables the production of a plane and smooth surface of a single crystalline silicon layer which is converted from a non-single crystalline silicon layer employing an energy ray irradiation process for conversion of non-single crystalline silicon to single crystalline silicon is provided.

It is needless to emphasize that the present invention can be realized not only on a silicon substrate but also on a substrate of any type of semiconductor. It is quite natural that the laser beam employed for the conversion of the polycrystalline silicon layer 3 to a single crystalline silicon layer 3' is only an example. The specific processes for the production of an insulating layer and windows described above can be also replaced by any other similar process.

It should be noted that the first embodiment of the present invention can be employed for the production of multi-layered semiconductor devices of which one example is illustrated in Fig. 5.

The same figure shows a double layered semiconductor device which comprises two layers of semiconductor devices each of which is identical or similar to the semiconductor devices illustrated in Fig. 4. Namely, after electrode pads 8 are placed on the required terminals of various elements included in the first layer of semiconductors, an insulating layer 9 is produced with a double purpose including firstly to provide insulation between two layers of semiconductors and secondly to provide a substrate for the second layer of semiconductors, on top of the semiconductor device shown in Fig. 4.

Refractory metals such as molybdenum and tungsten are preferable for the materials of the electrode pads 8, because it is required to function as a stopper during the etching process for the production of contact holes of the specific terminals, which etching process is scheduled to be conducted at the very end of the semiconductor device production process.

Therefore, the material for the insulating layer 9 is required to be selected from a group of materials which can be produced with a low temperature process and which allow a polycrystalline silicon layer with a good quality to be grown thereon. An experiment has shown that either silicon dioxide or silicon nitride is satisfactory.

The insulator layer 9 is removed from the selected areas including the linear areas 2A on the scribe lines and some areas on the terminals of various elements included in the first layer of semiconductors, for example $7_D$ shown in the same figure.

It is necessary that the insulator 9 remains on the areas under which the electrode pads 8 are buried to allow external bonding wires to be contacted in a later process.

A chemical vapor deposition process is employed to grow a polycrystalline silicon layer which is converted to a single crystalline silicon layer employing an energy ray irradiation process. In this latter process, the crystal nuclei are readily provided from the linear areas 2A on the scribe lines, because the polycrystalline silicon contacts with the single crystalline silicon substrate 1.

A selective oxidation process is employed for the production of field oxide layers 4'. Thereafter, similar semiconductor devices as were described in the first embodiment are produced thereon. Gate oxide layers 5' and gate electrodes 6', are produced. These are employed as masks for a process for the introduction of impurities to produce source regions $7'_s$ and drain regions $7'_D$. After electrode pads 8' are placed on the required terminals of various elements included in the second layer of semiconductors, an insulator layer 9' is produced for the same purposes as those of the first insulator layer 9 in the case of treble or more folded layers and for the purpose of passivation in the case of double layers.

The insulator layer 9' is removed for the purpose of exposing the electrode pads 8' and the second single crystalline layers which carries no elements or which covers the scribe lines.

A photo lithography process is employed to remove the second single crystalline layers exposed during the previous process.

A photo lithography process is again employed to remove the insulator layer 9' to expose the electrode pads 8'.

A scribing process is applied to split each chip, $Q_1$, $Q_2$, et al., along the scribe lines 2A.

Finally, after each chip is mounted in a package selected depending on the specific purpose of the specific semiconductor device, external wirings 10, 10', et al. are bonded onto the electrode pads 8, 8', et al.

Accordingly, in accordance with the aforementioned series of steps, a double layered semiconductor device which comprises two layers of semiconductor devices of which the first layer is identical to the semiconductor device illustrated in Fig. 4 and of which the second layer is similar to the semiconductor device illutrated in Fig. 4, is successfully produced.

From a practical view-point, a modification is provided because a further simplification of the process and flexibility in the selection of materials would be significant to diversify the concept of this embodiment. In accordance with the modification, the limitation to certain materials is removed. In other words, any type of insulators is allowed to be employed as the substrate. Quartz is a realistic example of the materials.

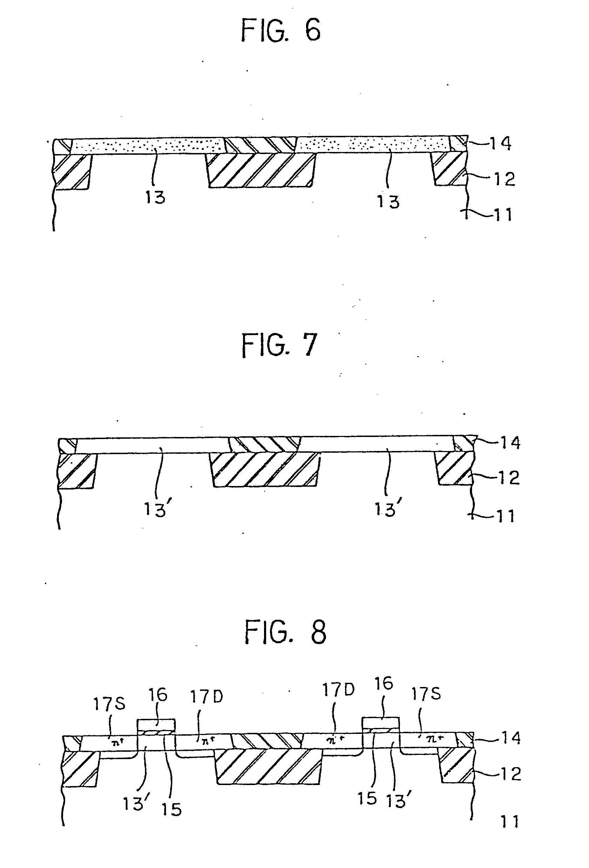

Referring to Figs. 6 through 8, each step of the second embodiment in accordance with the present invention which is realized to attain the third and fourth objects mentioned above, on a silicon substrate will be described below:

Referring to Fig. 6, the first step to apply a selective thermal oxidation process to a P type silicon substrate 11 which is sliced along the (100) crystalline surface, for the production of embedded field oxide layers 12 having the approximate thickness of 1 micrometer.

After removing the masks of silicon nitride ($Si_3N_4$) and silicon dioxide which were employed for the selective thermal oxidation process mentioned above, a chemical vapor deposition process is employed to grow a polycrystalline silicon layer 13 having the approximate thickness of 4,000 angstroms.

The third step is to employ a selective thermal oxidation process to produce embedded field oxide layers 14.

Referring to Fig. 7, the fourth step is to remove the masks of silicon nitride and silicon dioxide which were employed for the selective thermal oxidation process mentioned above.

The fifth step is to irradiate the polycrystalline silicon layer 13 with a laser beam for converting it into a single crystalline silicon layer 13'. An experimental result has showed that a Q switch YAG laser of 2W having the approximate beam diameter of 50 micrometers is effective to convert a polycrystalline silicon layer with the approximate thickness of 4,000 angstroms to a single crystalline silicon layer.

The subsequent steps are quite similar to those which are employed for the production of an ordinary semiconductor device. Referring to Fig. 8, gate insulating layers 15, silicon gate electrodes 16, source regions $17_S$, drain regions $17_D$ are produced. Finally, passivation layers (not shown) and wirings (not shown) are produced.

It is noted that the single crystalline silicon layer 13' has no opportunity to be exposed to high temperature. Therefore, it is possible to produce not only mesa type semiconductor devices but also planar type semiconductor devices. Accordingly, in accordance with the second embodiment of the present invention, a method for the production of semiconductor devices which method enables easy production of a planar type semiconductor device and in which method high temperature oxidation process for production of a field oxide layer is prevented from damaging a single crystalline silicon layer converted from a polycrystalline silicon layer employing an energy ray irradiation process for the conversion of polycrystalline silicon to single crystalline silicon.

It should be noted that the second embodiment of the present invention can be employed either for the production of a chip or for the production of elements produced on a chip. It should further be noted that the second embodiment of the present invention is employed for the production of multilayered semiconductor devices. It is particularly efficient to employ the first embodiment for the production of the first layer and the second embodiment for the production of the second and later layers.

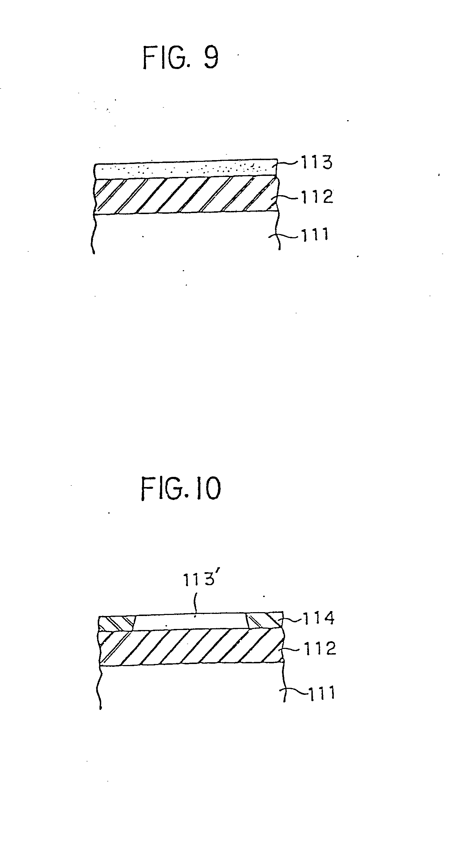

Referring to Figs. 9 and 10, the essential steps of the third embodiment in accordance with the present invention which is realized to attain the fifth object mentioned above, on a silicon substrate will be described below:

Referring to Fig. 9, the first step is to oxidize the top surface of a silicon substrate 111 to produce a silicon dioxide layer 112 with the approximate thickness of 1 micrometer.

The second step is to employ a chemical vapor deposition process for growing a polycrystalline silicon layer 113 having the approximate thickness of 4,000 angstroms on top of the silicon layer 112.

Referring to Fig. 10, the third step is to employ a selective thermal oxidation process to produce embedded field oxide layers 114.

The fourth step is to remove the masks of silicon nitride and silicon dioxide which were employed for the selective heat oxidation process mentioned above.

The fifth step is to irradiate the polycrystalline silicon layer 113 with a laser beam for converting it into a single crystal silicon layer 113'.

It is noted in this step that no crystal nuclei are available for the crystallization. The reason why the molten silicon makes a single crystalline silicon is that (a) the molten silicon is in a super-saturated condition in a relatively small confined space and that (b) the molten silicon is rapidly cooled.

The subsequent steps are quite similar to those which are employed for the production of an ordinary semiconductor device. Therefore, it is also noted that the single crystalline silicon layer 113' has no opportunity to be exposed to high temperature.

Accordingly, in accordance with the third embodiment of the present invention, there is provided a method for the production of semiconductor devices which method enables the conversion of a polycrystalline silicon layer to a single crystalline silicon layer without requiring crystal nuclei.

It should be noted for this third embodiment of the present invention that since this embodiment has a quite similar nature to that of the second embodiment, the quite similar applications to those of the second embodiment are assumed for this third embodiment. Accordingly the first embodiment is employed for production of the first layer and the third embodiment for the production of the second and later layers;

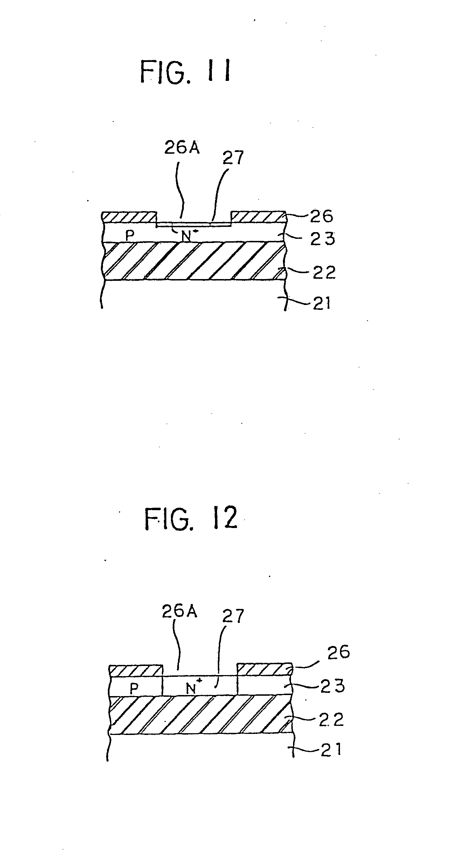

Referring to Figs. 11 and 12, the essential steps of the fourth embodiment in accordance with the present invention which is realized to attain the sixth and seventh objects mentioned above specifically for the purpose of producing an embedded semiconductor resistor additionally onto a semiconductor device produced on a single crystalline silicon layer which is converted from a polycrystalline silicon layer employing an energy ray irradiation process for the conversion of polycrystalline silicon to single crystalline silicon will be described below:

Referring to Fig. 11, the first step is to oxidize the top surface of a silicon substrate 21 to produce a silicon dioxide layer 22 having the approximate thickness of 1 micrometer.

The second step is to employ a chemical vapor deposition process for the production of a polycrystalline silicon layer having an approximate thickness of 0.5 micrometer.

The third step is to employ an ion implantation process for the implantation of boron $B^+$ ions to the approximate density of $1 \times 10^{16}/cm^3$.

The fourth step is to irradiate the polycrystalline silicon layer with a laser beam for converting it into a P type single crystalline silicon layer 23.

The fifth step is to produce various elements (not shown) on the P type single crystalline silicon layer 23. It is noted that high temperature processes are included in this step. However, it is also noted that no high temperature process is included in the subsequent steps.

The sixth step is to employ an evaporation process for the production of an aluminum layer 26 on the P type single crystalline silicon layer 23. The reason why aluminum is selected is that since an aluminum layer readily reflects energy rays, it allows little heat to pass therethrough. Accordingly, the aluminum layer functions as a layer which prevents heat given in the form of radiation from being transmitted to the P type single crystalline silicon layer 23. Therefore, aluminum can be substituted by any other material which prevents heat from passing therethrough. The seventh step is to employ a photo lithography process to pattern the aluminum layer 23 and to produce an opening 26A through which impurities are implanted in a subsequent process.

The eighth step is to employ an ion implantation process for implantation of arsenic ($As^+$) through the opening 26A of the aluminum mask 26 into the P type single crystalline silicon layer 23 and to produce a shallow region 27 containing N type impurities in the P type single crystalline silicon layer 23.

Referring to Fig. 12, the ninth step is to employ a laser annealing process to melt the single crystalline silicon in the region in which arsenic was implanted in the eighth step and then again to crystallize it for the ultimate purposes to cause the arsenic to diffuse in the single crystalline silicon layer 23 with a uniform density within a considerable magnitude of the depth and to activate the diffused arsenic. It should be noted in this step that the region of the P type single crystalline silicon layer 23 covered by the aluminum mask 26 is not melted and remains as single crystalline silicon to provide crystal nuclei. Accordingly, the molten silicon implanted with arsenic can be crystallized to allow the arsenic to uniformly diffuse in the region confined by the silicon dioxide layer 22 and the non-molten P type single crystalline silicon layer 23. As a result, an embedded semiconductor resistor of which the resistance is sufficiently low and uniform and is accurate in the shape of the diffused region can be readily produced.

The subsequent steps are quite similar to those which are employed for the production of an ordinary semiconductor device.

Accordingly, in accordance with the fourth embodiment of the present invention, there is provided a method for the production of semiconductor devices which enables self-aligned, deep and uniform diffusion of impurities in a semiconductor layer particularly in a single crystalline semiconductor layer converted from a polycrystalline semiconductor layer employing an energy ray irradiation process for the conversion of a polycrystalline semiconductor to a single crystalline semiconductor. Further, in accordance with this fourth embodiment of the invention, there is provided a method for the production of semiconductor devices which method enables the production of an embedded semiconductor resistor of which the resistance is definite and uniform in the magnitude and is accurate in the shape.

It should be noted in this fourth embodiment that the semiconductor in which impurities are implanted is not limited to a single crystalline semiconductor. In other words, a polycrystalline or amorphous semiconductor is acceptable. In the case of an amorphous semiconductor, the recrystallized semiconductor becomes a polycrystalline semiconductor.

This fourth embodiment is employed in combination with the first embodiment of the present invention.

Depending on the material employed as the mask for the energy ray irradiation process, the possibility cannot be denied of the occurence of a drawback. For example, aluminium can be a dopant for silicon and even react with silicon, particularly at the edge of a mask. This readily causes the possibility of the crystallization being prohibited and/or unintentional doping being realized. To prevent these potential drawbacks from occuring, a modification is provided in which the silicon layer to be converted to a single crystalline silicon layer is covered by a material which scarcely reacts with silicon and is not qualified as a dopant for silicon. A silicon dioxide layer has been determined to perform an excellent function without causing any adverse effect.

## Claims

1. A method for production of semiconductor devices which comprises:

a step to produce an insulating layer (2) on the top surface of a semiconductor substrate (1),

a step to produce at least one window (2A) in said insulating layer (2) along at least one elongated area on which a scribe line is scheduled to be produced,

a step to grow a non-single crystalline semiconductor layer (3) on the top surface of said insulating layer and on the substrate surface which is exposed through the window,

a step to irradiate said non-single crystalline semiconductor layer with an energy ray selected from a group consisting of a photon beam, an ion beam, and an electron beam, to convert said non-single crystalline semiconductor layer into a moncrystalline layer (3'), and

subsequently a step of scribing the line in the region where the said window (2A) is provided in the insulating layer.

2. A method as claimed in claim 1, which further comprises:

a step to grow a further non-single crystalline semiconductor layer on the top surface of a semiconductor substrate,

a step to selectively oxidize at least one selected area designated in said further non-single crystalline semiconductor layer, and

a step to irradiate said further non-single crystalline semiconductor layer, adjoining the selected oxidized area, with an energy ray selected from a group consisting of a photon beam, an ion beam, and an electron beam, to convert said further non-single crystalline semiconductor layer into a monocrystalline layer.

3. A method as claimed in any of the preceding claims, which further comprises:

a step to cover at least one selected area designated on a further semiconductor layer with a mask made of a material which prevents heat supplied in the form of radiation from passing therethrough,

a step to deposit impurities in the uncovered area of said further semiconductor layer, and

a step to irradiate said uncovered area of said further semiconductor layer so as to recrystallize it with an energy ray selected from a group consisting of a photon beam, an ion beam, and an electron beam, whereby the deposited impurities diffuse into the recrystallized semiconductor layer.

## Revendications

1. Procédé pour fabriquer des dispositifs à semiconducteurs, comprenant:

une étape pour produire une couche isolante (2) sur la face supérieure d'un substrate semiconducteur (1),

une étape pour ouvrir au moins une fenêtre (2A) dans cette couche isolante (2), le long d'au moins une zone de forme allongée où il est prévu d'exécuter un trait de rayage au diamant ou de réaliser une autre ligne de division,

une étape pour faire croître une couche (3) de matériau semi-conducteur non monocristallin sur la face supérieure de cette couche isolante et sur la surface du substrat exposée à travers la fenêtre,

une étape pour irradier la couche de matériau semi-conducteur non monocristallin au moyen d'un rayon d'énergie choisi dans un groupe comprenant un faisceau de photons, un faisceau d'ions et un faisceau d'électrons, afin de transformer la couche de matériau semi-conducteur non monocristallin en une couche monocristalline (3') et, ensuite,

une étape pour réaliser une ligne de division dans la région où la fenêtre (2A) avait été ouverte dans la couche isolante.

2. Procédé selon la revendication 1, comprenant en outre:

une étape pour faire croître une couche supplémentaire de matériau semi-conducteur non monocristallin sur la face supérieure d'un substrat semi-conducteur,

une étape pour oxyder sélectivement au moins une zone choisie dans cette couche supplémentaire et

une étape pour irradier cette couche supplémentaire, adjacente à la zone choisie et oxydée, par un rayon d'énergie choisi d'un groupe comprenant un faisceau de photons, un faisceau d'ions et un faisceau d'électrons, afin de transformer ladite couche supplémentaire en une couche monocristalline.

3. Procédé selon l'une quelconque des revendications précédentes, comprenant en outre:

une étape pour recouvrir au moins une zone choisie d'une couche de matériau semi-conducteur supplémentaire par un masque fait d'un matériau qui empêche la chaleur fournie sous forme de radiation de passer à travers ce masque,

une étape pour déposer des impuretés dans la zone non recouverte de cette couche de matériau semi-conducteur supplémentaire et

une étape pour irradier cette zone non recouverte de la couche supplémentaire, dans le but de produire sa recristallisation, par un rayon d'énergie choisi d'une groupe comprenant un faisceau de photons, un faisceau d'ions et un faisceau d'électrons, de maniére que les impuretés déposées diffusent dans la couche de matériau semi-conducteur recristallisé.

**Patentansprüche**

1. Verfahren zur Herstellung von Halbleitervorrichtungen, gekennzeichnet durch:

einen Schritt zur Erzeugung eine Isolierschicht (2) auf der Oberfläche eines Halbleitersubstrats (1),

einen Schritt zur Herstellung wenigstens eines Fensters (2A) in der genannten Isolierschicht (2) längs wenigstens einem länglichen Bereich, auf welchem eine Ritzlinie erzeugt werden soll,

einen Schritt zum Wachsen eine nicht-einkristallinen Halbleiterschicht (3) auf der Oberfläche der genannten Isolierschicht und auf der Substratoberfläche, welche durch das Fenster exponiert ist,

einen Schritt zum Bestrahlen der nicht-einkris-tallinen Halbleiterschicht mit einem Energie-strahl ausgewählt au der Gruppe bestehend aus einem Photonenstrahl, einem Ionen-strahl und einem Elektronenstrahl, um die genannte nicht-einkristalline Halbleiterschicht in eine einkristalline Schicht (3') umzuwandeln, und

einen folgenden Schritt zum Ritzen der Linie in dem Bereich, wo das genannte eine Fenster in der Isolierschicht vorgesehen ist.

2. Verfahren nach Anspruch 1, ferner gekennzeichnet durch:

einen Schritt zum Wachsen einer weiteren nicht-einkristallinen Halbleiterschicht auf der Oberfläche eines Halbleitersubstrats,

einen Schritt zum wahlweisen Oxidieren von wenigstens einem ausgewählten Bereich, der in der genannten weiteren nicht-einkristallinen Halbleiterschicht bestimmt ist, und

einen Schritt zur Bestrahlung der genannten weiteren nicht-einkristallinen Halbleiterschicht, welche an den ausgewählten oxidierten Bereich angrenzt, mit einem Energiestrahl, der ausgewählt ist aus der Gruppe bestehend aus einem Photonenstrahl, einem Ionenstrahl und einem Elektronenstrahl, um die genannte weitere nicht-kristalline Halbleiterschicht in eine mono-kristalline Schicht umzuwandeln.

3. Verfahren nach einem der vorhergehenden Ansprüche, ferner gekennzeichnet durch:

einen Schritt zur Bedeckung von wenigstens einem ausgewählten Bereich, welcher auf einer weiteren Halbleiterschicht bestimmt ist, mit einer Maske bestehend aus einem Material, welches verhindert, daß in Form von Strahlung zugeführte Hitze hindurch tritt,

einen Schritt zur Abscheidung von Verunreinigungen in dem unbedeckten Bereich der genannten weiteren Halbleiterschicht und

einen Schritt zur Bestrahlung der unbedeckten Bereichs der weiteren Halbleiterschicht, um diese zu rekristallisieren, mit einem Energiestrahl, der ausgewählt ist aus einer Gruppe bestehend aus einem Photonenstrahl, einem Ionenstrahl und einem Elektronenstrahl, wodurch die abgeschiedenen Verungeinig-ungen in due rekristallisierte Halbleiter-schicht diffundieren.

# FIG. 1

# FIG. 2

# FIG. 3

# FIG. 4

# FIG. 5

## FIG. 6

14

13  12

13  11

## FIG. 7

14

13'  12

13'  11

## FIG. 8

17S  16  17D  17D  16  17S

$n^+$  $n^+$  $n^+$  $n^+$  14

12

13'  15  15  13'

11

# FIG. 9

113
112
111

# FIG. 10

113′
114
112
111

FIG. 11

FIG. 12